(19) Europäisches Patentamt
European Patent Office
Office européen des brevets

(11) Publication number: 0 437 259 A2

(12) EUROPEAN PATENT APPLICATION

(21) Application number: 91100257.4

(51) Int. Cl.[5]: G03F 7/031, G03F 7/00

(22) Date of filing: 10.01.91

(30) Priority: 12.01.90 US 465823

(43) Date of publication of application:
17.07.91 Bulletin 91/29

(84) Designated Contracting States:
CH DE FR GB IT LI NL

(71) Applicant: E.I. DU PONT DE NEMOURS AND COMPANY
1007 Market Street
Wilmington Delaware 19898(US)

(72) Inventor: Laganis, Evan Dean
204 West Crest Road
Wilminton, Delaware 19803(US)
Inventor: Trout, Torence John
P.O. Box 305
Yorklyn, Delaware 19736(US)
Inventor: Serino, Anthony J.
1143 Pynchon Hall Road
West Chester, Pennsylvania 19382(US)
Inventor: Weber, Andrew Michael
2605 Nelson Lane
Wilmington, Delaware 19808(US)

(74) Representative: Werner, Hans-Karsten, Dr. et al
Deichmannhaus am Hauptbahnhof
W-5000 Köln 1(DE)

(54) **Photopolymerizable compositions sensitive to longer wavelength visible actinic radiation.**

(57) Photopolymerizable compositions having extended spectral response are disclosed which contain (a) a squarylium sensitizer, (b) hexaarylbisimidazole (c) monomer and (d) chain transfer agent.

EP 0 437 259 A2

# PHOTOPOLYMERIZABLE COMPOSITIONS SENSITIVE TO LONGER WAVELENGTH VISIBLE ACTINIC RADIATION

## Field of the Invention

This invention relates to photopolymerizable compositions containing initiator systems that absorb in the longer wavelength region of the visible spectrum. More particularly, this invention pertains to photopolymerizable compositions containing selected photodissociable initiators in combination with selected squarylium sensitizers.

## Background of the Invention

Many of the well-known photoinitiators or photoinitiator systems limit the applicability of photopolymerizable compositions because they are activatable primarily by radiation in the ultraviolet or shorter wavelength region (i.e., blue and green) of the visible spectrum. The availability of reliable, relatively inexpensive lasers which emit in the longer wavelength (i.e., red) region of the visible spectrum and which can be used as output devices for electronic imaging systems has made it desirable to develop initiator systems which are activatable by this spectral region. Applications for photopolymerizable compositions containing these initiator systems include graphic arts films, proofing, printing plates, and photoresists. The preparation of holograms in photopolymerizable compositions, such as are disclosed in Haugh, U.S. Patent 3,658,526, and published EPO patent applications 89 100 495.4 and 89 100 498.8, also require initiator systems activatable by radiation in this spectral region.

A large number of free-radical generating systems have been utilized as visible sensitizers for photopolymerizable compositions. Photoreducible dyes and reducing agents; ketones; quinones; and dye-borate complexes, as disclosed in U.S. Patent 4,772,541, have been used to initiate photopolymerization. A useful discussion of dye sensitized photopolymerization can be found in "Dye Sensitized Photopolymerization" by D. F. Eaton in Adv. in Photochemistry, Vol. 13, D. H. Volman, G. S. Hammond, and K. Gollinick, eds., Wiley-Interscience, New York, 1986, pp. 427-487.

Photopolymerizable compositions containing 2,2',4,4',5,5'-hexaarylbisimidazoles, or HABI's, are well known. Sensitizers which extend the sensitivity of these compositions are disclosed in a number of patents. Baum and Henry, U.S. Patent 3,652,275, discloses photopolymerizable compositions containing selected bis(p-dialkylaminobenzylidene)ketones as sensitizers of HABI initiator systems. Dueber, U.S. Patent 4,162,162, discloses selected sensitizers derived from aryl ketones and p-dialkylaminoaldehydes. Dueber and Monroe, U.S. Patent 4,565,769, discloses photopolymerizable compositions containing polymeric sensitizers which are activatable by visible radiation. However, the sensitizers disclosed in these patents are useful primarily in the shorter wavelength region of the visible spectrum.

## Summary of the Invention

It is an object of this invention to provide photopolymerizable compositions having extended sensitivity into the longer wavelength visible spectral region. It is a further object of this invention to provide a process for the preparation of holograms using lasers which emit in this region of the spectrum.

In one embodiment of this invention there is provided a photopolymerizable composition having extended spectral response, said composition comprising:

(a) a squarylium sensitizer of the following structure:

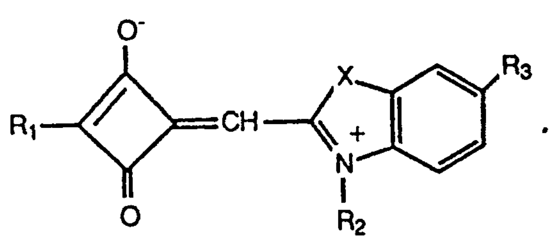

where

$R_1$ is:

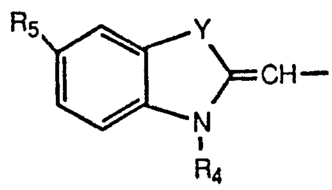

,

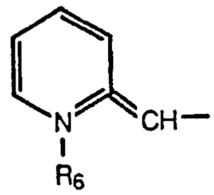

,

A

B

or a p-(N,N-dialkylamino)phenyl in which the alkyl groups are from about 1 to about 4 carbon atoms;

X and Y are each independently O, S, $NR_7$, or $CR_8R_9$, where $R_7$, $R_8$, and $R_9$ are each independently an alkyl group of about 1 to about 6 carbon atoms or substituted or unsubstituted phenyl;

$R_2$ and $R_4$ are each independently a substituted or unsubstituted alkyl group from about 1 to about 7 carbon atoms;

$R_3$ and $R_5$ are each independently H, Cl, or $OCH_3$ with the proviso that when X is Sr $R_3$ is H and that when Y is S, $R_5$ is H; and

$R_6$ is a substituted or unsubstituted alkyl group of from about 1 to about 8 carbon atoms;

(b) a hexaarylbisimidazole of the following structure:

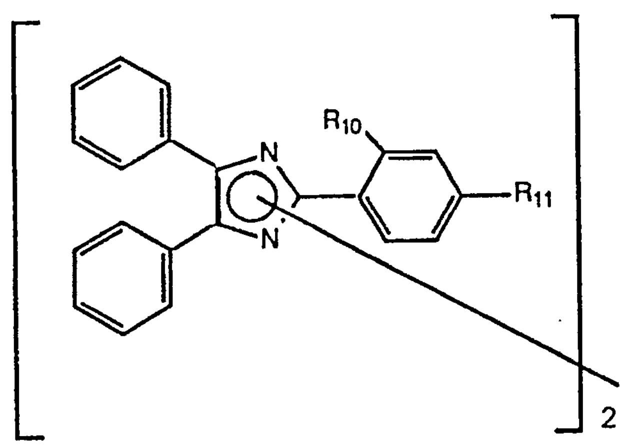

where

$R_{10}$ is Cl, H or $CH_3$, and $R_{11}$ is Cl $NO_2$, H, $CH_3$ or $OCH_3$ with the proviso that either $R_{10}$ is Cl or $R_{11}$ is Cl or $NO_2$; and, any other position on the three phenyl radicals of (b) is either unsubstituted or substituted with Cl, $CH_3$ or $OCH_3$;

(c) at least one an ethylenically unsaturated monomer capable of free radical initiated addition polymerization; and

(d) a chain transfer agent.

In a preferred embodiment of this invention, X and Y are each independently S or $CR_8R_9$. In a more preferred embodiment of this invention, the squarylium sensitizer is symmetrical, that is, $R_1$ is moiety A, X and Y are identical, $R_2$ and $R_4$ are identical, and R3 and $R_5$ are identical. In a still more preferred embodiment of this invention the hexaarylbisimidazole is o-Cl-HABI, CDM-HABI, TCTM-HABI, or p-$NO_2$-HABI. In a preferred embodiment of this invention a polymeric binder is also present.

In another embodiment of this invention there is provided a process for forming a light-stable hologram which comprises exposing to modulated actinic radiation comprising an object beam and a reference beam bearing holographic information a photopolymerizable layer comprising:

(a) a squarylium sensitizer of the following structure:

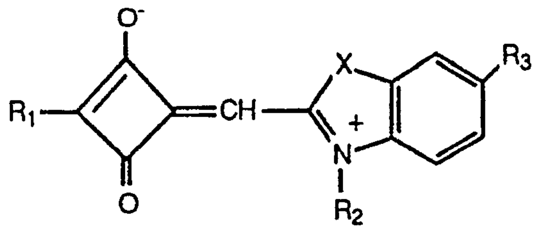

where
$R_1$ is:

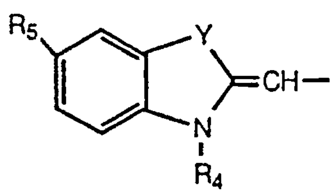

A

,

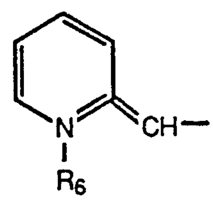

B

,

or a p-(N,N-dialkylamino)phenyl in which the alkyl groups are from about 1 to about 4 carbon atoms;
X and Y are each independently O, S, $NR_7$, or $CR_8R_9$, where $R_7$, $R_8$, and $R_9$ are each independently an alkyl group of about 1 to about 6 carbon atoms or substituted or unsubstituted phenyl;
$R_2$ and $R_4$ are each independently a substituted or unsubstituted alkyl group from about 1 to about 7 carbon atoms;
$R_3$ and $R_5$ are each independently H, Cl, or $OCH_3$ with the proviso that when X is S, $R_3$ is H and that when Y is S, $R_5$ is H; and
$R_6$ is a substituted or unsubstituted alkyl group of from about 1 to about 8 carbon atoms; (b) a hexaarylbisimidazole of the following structure:

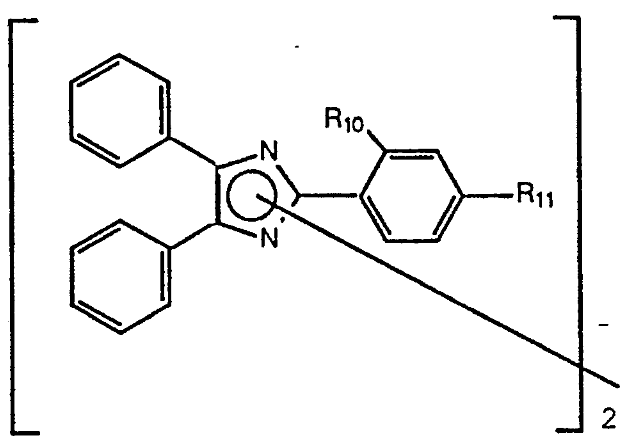

where
$R_{10}$ is Cl, H or $CH_3$, and $R_{11}$ is Cl, $NO_2$, H, $CH_3$ or $OCH_3$ with the provisio that either $R_{10}$ is Cl or $R_{11}$ is Cl or $NO_2$; and, any other position on the three phenyl radicals of (b) is either unsubstituted or substituted with Cl, $CH_3$ or $OCH_3$;
(c) a solvent soluble, polymeric binder; and
(d) at least one ethylenically unsaturated monomer capable of free radical initiated addition polymerization and having a boiling point above 100 °C.

In a preferred embodiment of this invention, X and Y are each independently S or $CR_8R_9$. In a more preferred embodiment of this invention, the squarylium sensitizer is symmetrical, that is, $R_1$ is moiety A, X and Y are identical, $R_2$ and $R_4$ are identical, and $R_3$ and $R_5$ are identical. In a preferred embodiment of this invention the hexaarylbisimidazole is o-Cl-HABI, CDM-HABI, TCTM-HABI, or p-$NO_2$-HABI.

In a preferred embodiment of this invention, the hologram is fixed by a second, overall exposure to actinic radiation. In a more preferred embodiment of this invention either the monomer or the binder contains a substituent selected from the group consisting of (1) an aromatic moiety selected from the group consisting of (i) substituted or unsubstituted phenyl, (ii) substituted or unsubstituted naphthyl, and (iii) substituted or unsubstituted heterocyclic aromatic moiety having up to three rings; (2) chlorine; (3) bromine and mixtures thereof; and the other constituent is substantially free of said substituent. In a still more preferred embodiment of this invention, the hologram is a reflection hologram; the monomer contains the selected substituent; the binder is poly(vinyl butyral), poly(vinyl acetate), or a copolymer of vinyl acetate with tetrafluoroethylene and/or hexafluoropropylene containing 3 to 25% by weight fluorine; and the hologram is heated to 100-150 °C for about 0.5-1.5 hr following overall exposure. In the most preferred embodiment of this invention the binder is a copolymer of vinyl acetate with tetrafluoroethylene and/or hexafluoropropylene containing 3 to 25% by weight fluorine.

## Detailed Description of the Invention Photopolymerizable Compositions

The novel compositions of this invention are photopolymerizable compositions in which polymerization is initiated by free radicals generated by actinic radiation. As described herein, these compositions comprise a squarylium sensitizer; a hexaarylbisimidazole; a polymerizable monomer; a chain transfer agent; and, optionally, a binder. The composition may also comprise other ingredients for a specific use. Such constituents comprise stabilizers, adhesion and coating agents, and the like.

## Squarylium Sensitizers

The squarylium sensitizers of this invention have the structure:

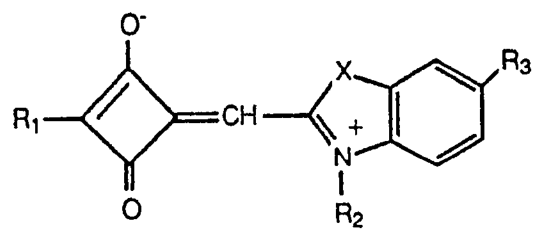

where

$R_1$ is:

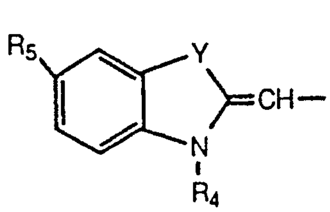

,

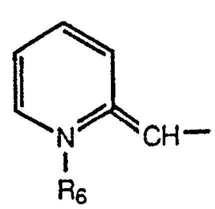

,

A

B

or a p-(N,N-dialkylamino)phenyl in which the alkyl groups are from about 1 to about 4 carbon atoms;

X and Y are each independently O, S, $NR_7$, or $CR_8R_9$, where $R_7$ $R_8$, and $R_9$ are each independently an alkyl group of about 1 to about 6 carbon atoms or substituted or unsubstituted phenyl;

$R_2$ and $R_4$ are each independently a substituted or unsubstituted alkyl group from about 1 to about 7

carbon atoms;

$R_3$ and $R_5$ are each independently H, Cl, or $OCH_3$ with the proviso that when X is S, $R_3$ is H and that when Y is S, $R_5$ is H; and

$R_6$ is a substituted or unsubstituted alkyl group of from about 1 to about 8 carbon atoms.

The sensitizers of this invention are illustrated by sensitizers S-1 to S-6.

| SENSITIZER | # |
|---|---|
| 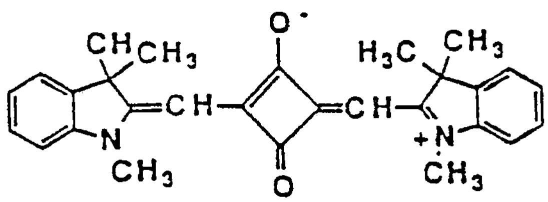 | 1 |
| 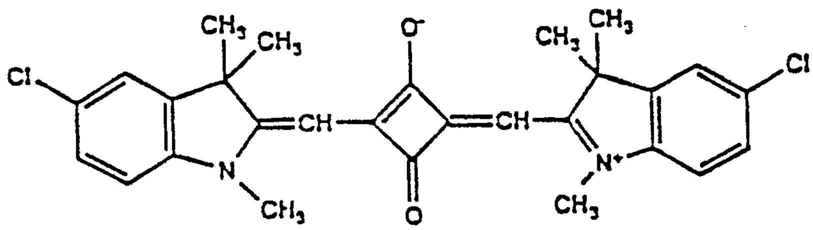 | 2 |
| 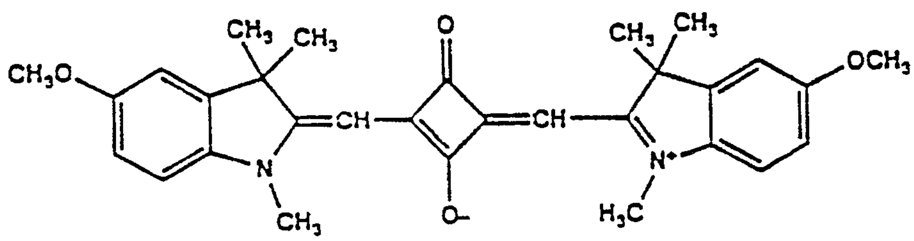 | 3 |
| 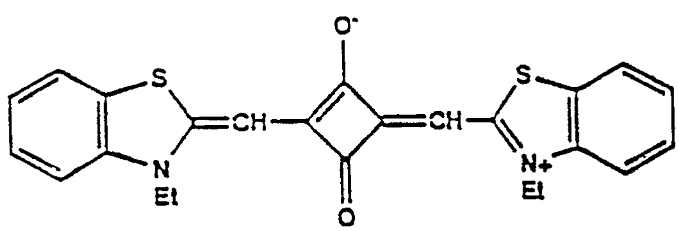 | 4 |
| 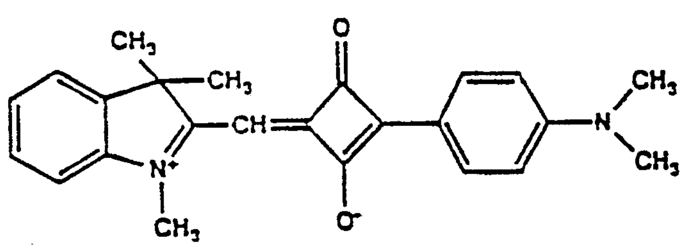 | 5 |
| 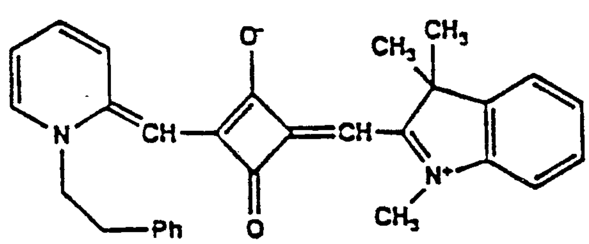 | 6 |

In a preferred embodiment of this invention, X and Y are each independently S or $CR_8R_9$. The preferred sensitizers of this invention are illustrated by sensitizers S-1 to S-6.

In a more preferred embodiment of this invention the squarylium sensitizers are symmetrical. In these compounds $R_1$ is moiety A; X and Y are identical and equal to $C(CH_3)_2$; $R_2$ and $R_4$ are identical and equal to $CH_3$ or $C_2H_5$; and $R_3$ and $R_5$ are identical. The more preferred sensitizers of this invention are illustrated by sensitizers S-1 to S-3.

In a still more preferred embodiment of this invention $R_1$ is moiety A; X and Y are identical and equal to $C(CH_3)_2$; $R_2$ and $R_4$ are identical and equal to $CH_3$; and $R_3$ and $R_5$ are identical and equal to H or Cl. The still more preferred sensitizers of this invention are illustrated by sensitizers S-1 and S-2.

The most preferred sensitizer is sensitizer S-1, in which $R_1$ is moiety A; X and Y are identical and equal to $C(CH_3)_2$, $R_2$ and $R_4$ are identical and equal to $CH_3$; and $R_3$ and $R_5$ are identical and equal to H.

The sensitizers of this invention may be used individually or in combination with other members of the same class of sensitizers or with other sensitizing compositions, such as the bis (p-dialkylaminobenzylidene)ketones disclosed in Baum and Henry, U.S. Patent 3,652,275, or the sensitizers derived from aryl ketones and p-dialkylaminoaldehydes disclosed in Dueber, U.S. Patent 4,162,162. The use of two or more such compositions effects sensitization over a broader spectral range to match a variety of laser output radiation.

Since the sensitizers of this invention are sensitive to actinic radiation in the red region of the visible spectrum, they may be combined with one or more sensitizers which are sensitive to the actinic radiation in the blue and green regions of the visible spectrum to produce photopolymerizable compositions with broad sensitivity across the visible spectrum. By this procedure it is possible to produce photopolymerizable compositions in which multiple holograms, each generated by actinic radiation of a different wavelength, can be prepared. A particularly useful sensitizer combination is a combination of sensitizer 1 with JAW, i.e., cyclopentanone, 2,5-bis[(2,3,6,7-tetrahydro-1H,5H-benzo[i,j]quinolizin-9-yl)methylene]-. Irradiation of a photopolymerizable composition comprising this combination of sensitizers with actinic radiation at 488 nm (argon-ion laser), 514 nm (argon-ion laser), and 647 nm (krypton-ion laser) produces multicolor holograms. A tunable dye laser, such as, for example, a continuous wave dye laser with a ring dye cavity pumped by a continuous wave argon-ion or krypton-ion laser, can also be advantageously used to produce multicolor holograms.

## Hexaarylbisimidazoles

The squarylium sensitizers of this invention are used in conjunction with a 2,2',4,4',5,5'-hexaarylbisimidazole, or HABI. These compounds, which dissociate on exposure to actinic radiation to form the corresponding triarylimidazolyl free radicals which initiate polymerization, have been described in a number of patents. These include: Chambers, U.S. Patent 3,479,185; Chang et al., U.S. Patent 3,549,367; Cescon, U.S. Patent 3,784,557; Dessauer, U.S. Patent 4,252,887; Chambers et al., U.S. Patent 4,264,708; and Tanaka et al., U.S. Patent 4,459,349. The hexaarylbisimidazoles absorb maximally in the 255-275 nm region of the spectrum, and usually show some, though lesser, absorption in the 300-375 nm region. Although the absorption bands tend to tail out to include wavelengths as high as 430 nm, these compounds normally require light rich in the 255-375 nm region of the spectrum for their dissociation.

Although numerous HABI's are known, surprisingly, only a selected group have been found to be useful in the practice of this invention. Useful HABI's include the 2,2'-bis(o-chloro)-substituted, 2,2'-bis(p-chloro)-substituted, and 2,2'-bis(p-nitro)-substituted hexaphenylbisimidazoles in which the other positions on the phenyl radicals are unsubstituted or substituted with one or more chloro, methyl or methoxy groups. Preferred HABI's include the 2,2'-bis(o-chloro)-substituted and 2,2'bis(p-nitro)-substituted hexaphenylbisimidazoles in which the other positions on the phenyl radicals are unsubstituted or substituted with one or more chloro, methyl or methoxy groups. More preferred are HABI's in which the other positions on the phenyl radicals are unsubstituted or substituted with one or more methoxy groups. Selected compounds of this class are disclosed in Dessauer, U.S. Patent 4,252,887. The most preferred HABI'S are o-Cl-HABI, i.e., 1,1'-biimidazole, 2,2'-bis(o-chlorophenyl)-4,4',5,5'-tetraphenyl-; CDM-HABI, i.e., 2(o-chloro-phenyl)-4,5-bis(m-methoxyphenyl)-imidazole dimer; p-$NO_2$-HABI, i.e., 1,1'-biimidazole, 2,2'bis[p-nitrophenyl]-4,4',5,5'-tetraphenyl-; and TCTM-HABI, i.e., 1H-imidazole, 2,5-bis(o-chlorophenyl)-4-[3,4-dimethoxyphenyl]-, dimer.

## Chain Transfer Agents

Conventional chain transfer agents, or hydrogen donors, are used with HABI-initiated photopolymerizable systems. Suitable chain transfer agents include organic thiols, such as 2-mercaptobenzothiazole, 2-mercaptobenzoxazole, and 2-mercaptobenzimidazole. Others which can be used include various tertiary amines known in the art, N-phenylglycine, and 1,1-dimethyl-3,5-diketocyclohexane. Except for systems which contain N-vinyl carbazole monomer, the preferred chain transfer agents are 2-mercaptobenzoxazole and 2-mercaptobenzthiazole. For photopolymerizable compositions which contain the monomer N-vinyl carbazole, the preferred chain transfer agents are: 5-chloro-2-mercaptobenzothiazole; 2-mercaptobenzothiazole; 1-H-1,2,4-triazole-3-thiol; 6-ethoxy-2-mercaptobenzothiazole; 4-methyl-4H-1,2,4-triazole-3-thiol; and 1-dodecanethiol.

Monomers/Binders

Monomers are ethylenically unsaturated compounds which undergo free-radical initiated polymerization to form high molecular weight compound. Typical monomers are: unsaturated esters of alcohols, preferably polyols, such as, diethylene glycol diacrylate, glycerol triacrylate, ethylene glycol dimethacrylate, pentaerythritol tri- and tetraacrylate and methacrylate; unsaturated amides, such 1,6-hexamethylene bisacrylamide; vinyl esters such as divinyl succinate, divinyl phthalate, and divinyl benzene-1,3-disulfonate; styrene and derivatives thereof; and N-vinyl compounds, such as N-vinyl carbazole. Numerous other unsaturated monomers polymerizable by free-radical initiated polymerization and useful in photopolymerizable compositions are known to those skilled in the art.

The binder is an optional component present in the preferred photopolymerizable compositions of this invention. The binder is a preformed macromolecular polymeric or resin material. In general, the binder should be soluble in the coating solvent and compatible with the other components of the photopolymerizable system. Representative binders are poly(methyl methacrylate) and copolymers of methyl methacrylate with other alkyl acrylates, alkyl methacrylates, methacrylic acid, and/or acrylic acid; poly(vinyl acetate) and its partially hydrolyzed derivatives; gelatin; cellulose esters and ethers, such as cellulose acetate butyrate; and polyethylene oxides. Numerous other binders useful in photopolymerizable compositions are known to those skilled in the art.

In the preferred compositions adapted for the preparation of holograms either the monomer or the binder contains a substituent selected from the group consisting of (1) an aromatic moiety selected from the group consisting of (i) substituted or unsubstituted phenyl, (ii) substituted or unsubstituted naphthyl, and (iii) substituted or unsubstituted heterocyclic aromatic moiety having up to three rings; (2) chlorine; (3) bromine and mixtures thereof; and the other constituent is substantially free of said substituent. In the instance when the monomer contains the substituent, the photopolymerizable system hereinafter is identified as a "monomer oriented system" and when the binder contains this substituent, the photopolymerizable system hereinafter is identified as a "binder oriented system".

The monomer of a monomer oriented system is a compound capable of free radical initiated addition polymerization and having a boiling point above 100°C, preferably above 150°C, which contains one or more substituents taken from the indicated group. The monomer contains at least one such substituent and may contain two or more of the same or different substituents of the group. A liquid monomer will generally be selected, but solid monomers can be used to advantage, either individually or in combination with one or more liquid monomers, provided the solid monomer is capable of interdiffusion in the substantially solid film composition.

A preferred class of monomers for use in the monomer orientated system are liquid, ethylenically unsaturated compounds capable of addition polymerization and having a boiling point above 100°C, preferably above 150°C, which contain one or more substituents taken from the indicated group. Preferred liquid monomers for use in the monomer orientated system are: 2-phenoxyethyl acrylate, 2-phenoxyethyl methacrylate, phenol ethoxylate monoacrylate, 2-(p-chlorophenoxy)ethyl acrylate, p-chlorophenyl acrylate, phenyl acrylate, 2-phenylethyl acrylate, 2-(1-naphthyloxy)ethyl acrylate, o-biphenyl methacrylate, o-biphenyl acrylate, and mixtures thereof.

While most monomers useful in the monomer orientated system are liquids, they may be used in admixture with one or more ethylenically unsaturated solid monomers. Preferred solid monomers are: N-vinyl carbazole; 2,4,6-tribromophenyl acrylate or methacrylate; pentachlorophenyl acrylate or methacrylate; 2-naphthyl acrylate or methacrylate; 2-(2-naphthyloxy)ethyl acrylate or methacrylate; and mixtures thereof.

The binder of the monomer oriented system is substantially free of substituents taken from the indicated group. Preferred binders for the monomer orientated system are cellulose acetate butyrate; poly(methyl methacrylate); poly(vinyl butyral); poly(vinyl acetate); and fluorine containing binders containing 3 to 25% by weight fluorine, such as copolymers of vinyl acetate with tetrafluoroethylene and/or hexafluoropropylene. For reflection holograms, the preferred binders are poly(vinyl butyral), poly(vinyl acetate), and copolymers of vinyl acetate with tetrafluoroethylene and/or hexafluoropropylene containing 3 to 25% by

weight fluorine, such the 82:18 (weight %) vinyl acetate/tetrafluoroethylene copolymer. These copolymers can be prepared by the copolymerization of vinyl acetate with the fluorinated monomer using standard free radical polymerization techniques.

The monomer of the binder oriented system is a compound capable of free radical initiated addition polymerization and having a boiling point above 100° C, preferably above 150° C, which does not contain a substituent taken from the indicated group. Representative monomers for the binder orientated system are triethyleneglycol diacrylate and dimethacrylate, diethyleneglycol diacrylate, decanediol diacrylate, ethoxyethoxyethyl acrylate, and iso-bornyl acrylate.

The binder of the binder orientated system contains in its polymeric structure substituents taken from the indicated group. Preferred binders for the binder orientated system are polystyrene and copolymers containing at least about 60% styrene. Particularly preferred binders include polystyrene, 75:25 poly(styrene/acrylonitrile), and 70:30 poly(styrene/methyl methacrylate), as well as mixtures thereof.

If crosslinking of the photopolymer is desired, up to about five weight percent of at least one multifunctional monomer containing two or more terminal ethylenically unsaturated groups may be incorporated into the composition. The polyfunctional monomer must be compatible with the other components of the composition and is preferably a liquid. Suitable multifunctional monomers include di-(2-acryloxyethyl)-ether of bisphenol A, ethoxylated bisphenol A diacrylate, and the like. A preferred crosslinking is ethoxylated bisphenol A diacrylate.

## Other Components

Other components conventionally added to photopolymerizable compositions can be present to modify the physical properties of the film. Such components include: plasticizers, thermal stabilizers, optical brighteners, ultraviolet radiation absorbing material, adhesion modifiers, coating aids, and release agents.

A plasticizer may be present to modify adhesion, flexibility, hardness, and other mechanical properties of the film in a conventional fashion. When a binder is present, a plasticizer would be selected which is compatible with the binder as well as the ethylenically unsaturated monomer and other components of the composition. With acrylic binders, for example, plasticizers can include dibutyl phthalate and other esters of aromatic acids; esters of aliphatic polyacids, such as diisooctyl adipate; aromatic or aliphatic acid esters of glycols, polyoxyalkylene glycols, aliphatic polyols; alkyl and aryl phosphates; and chlorinated paraffins. In general, water insoluble plasticizers are preferred for greater high humidity storage stability, but are not necessary to get improved latitude.

Many ethylenically unsaturated monomers are subject to thermal polymerization, especially when stored for long periods or at elevated temperatures. Normally a thermal polymerization inhibitor will be present to improve the storage stability the photopolymerizable composition. Useful thermal stabilizers include: hydroquinone, phenidone, p-methoxyphenol, alkyl and aryl-substituted hydroquinones and quinones, t-butyl catechol, pyrogallol, beta-naphthol, 2,6-di-t-butyl-p cresol, phenothiazine, and chloranil. The dinitroso dimers described in Pazos, U.S. Patent 4,168,982, are also useful. Since monomers generally contain thermal polymerization inhibitors added by their manufacturers, it is frequently unnecessary to add additional inhibitor.

Nonionic surfactants may be added to the photopolymerizable composition as coating aids. Typical coating aids are polyethylene oxides, such as Polyox® WSRN, and fluorinated nonionic surfactants, such as Fluorad® FC-430 and Fluorad® FC-431.

By the incorporation of optical brightening agents into the photopolymerizable layer, the image record is produced free from distortion due to halation effects. Suitable optical brighteners useful in the process of the invention include those disclosed in, U.S. Patents 2,784,183; 3,664,394; and 3,854,950. Specific optical brighteners which are particularly useful in the photopolymerizable elements of this invention are 2-(stibyl-4")-(naphto-1',2',4,5)-1,2,3-triazol-2"-sulfonic acid phenyl ester and 7-(4'chloro-6'-diethyl-amino-l',3',5'-triazine-4'-yl)amino-3-phenyl coumarin. Ultraviolet radiation absorbing materials useful in the invention are also disclosed in U.S. Patent 3,854,950.

Depending on the application, other inert additives can be employed such as dyes, pigments and fillers. These additives are generally present in minor amounts so as not to interfere with the exposure of the photopolymerizable layer.

## Composition

While the composition of the photopolymerizable composition will depend on the intended application, in general, the proportions of ingredients will generally be within the following percentage ranges, based on

the total weight of the composition: photoinitiator system (squarylium sensitizer, HABI, and chain transfer agent) about 0.3% to about 15%; monomer about 80% to about 99%; binder about 0% to about 90%; and other ingredients about 0% to about 5%. If the composition is to be used as a dry film, the binder should be at least about 25% and the monomer should not exceed about 60%. While the amount of squarylium sensitizer present will depend on the thickness of the layer and the desired optical density for the intended application, in general, about 0.01% to about 0.50%, preferably about 0.02% to about 0.16% will be present.

For photopolymerizable compositions adapted for the preparation of holograms proportions of ingredients will generally be within the following percentage ranges, based on the total weight of the composition: binder, 25 to 90%, preferably 45 to 75%; monomer(s), 5 to 60%, preferably, 15 to 50%; plasticizer, 0 to 25%, preferably, 0 to 15%; photoinitiator system, 0.1 to 10%, preferably 1 to 7%; and other ingredients, 0 to 5%, typically 0 to 4%. If the amount of binder is below approximately 25%, or the amount of monomer exceeds approximately 60%, the composition has insufficient viscosity to form a solid film. At high levels of binder addition, exceeding approximately 90%, performance is unduly lost, and the resulting films have diminished values of refractive index modulation. Likewise, levels of monomer(s) used will be at least approximately 5% since lower quantities will not produce films having practical values of refractive index modulation.

Substrates/Coating

The photopolymerizable compositions can be coated onto a wide variety of substrates. By "substrate" is meant any natural or synthetic support, preferably one which is capable of existing in a flexible or rigid form. For example, the substrate can be a metal sheet or foil, a sheet or film of synthetic organic resin, cellulose paper, fiberboard, and the like, or a composite of two or more of these materials.

The particular substrate will generally be determined by the intended application. For example, when printed circuits are produced, the substrate may be a plate which is a copper coating on fiberboard; in the preparation of of lithographic printing plates, the substrate may be anodized aluminum. Specific substrates include alumina-blasted aluminum, anodized aluminum, alumina-blasted polyethylene terephthalate film, polyethylene terephthalate film, e.g., resin-subbed polyethylene terephthalate film, polyvinyl alcohol-coated paper, cross-linked polyester-coated paper, nylon, glass, cellulose acetate film, heavy paper such as lithographic paper, and the like. For the preparation of holograms, polyethylene terephthalate film is preferred.

Exposure

Any convenient source or sources of actinic radiation providing wavelengths in the region of the spectrum that overlap the absorption bands of the photosensitizer can be used to activate photopolymerization. The radiation can be natural or artificial, monochromatic or polychromatic, incoherent or coherent, and for high efficiency should correspond closely to in wavelength to the absorption of the initiator system.

Conventional light sources include fluorescent lamps, mercury, metal additive and arc lamps. Coherent light sources are xenon, argon ion, and ionized neon lasers, as well as tunable dye lasers and the frequency doubled neodymium:YAG laser, whose emissions fall within or overlap the visible absorption bands of the sensitizer.

For the exposure of holographic photopolymer systems coherent light sources, i.e., lasers, are required. Typically ion lasers, which have the required stability and coherence length but operate at a few lines of fixed wavelength, are used. With the development of photopolymer films that are sensitized across the visible spectrum, tunable lasers are required to match the broad spectral sensitivity of these materials. Since it is often desirable to record the hologram or holographic optical element (i.e., a hologram which acts as a diffraction grating, a mirror, a lens, or a combination of optical elements) with the same wavelength actinic radiation which will be used for reconstruction, tunable lasers offer added flexibility of recording a hologram and making a holographic optical element at any desired wavelength or at more than one selected wavelength.

Many wavelength tunable laser sources are now practical and can be used for holography. One type of tunable laser, the dye laser, can operate at any wavelength from the ultraviolet to the infra-red by the proper choice of pump source and dye medium. Dye laser systems can be pulsed with pulses of light as short as a few femtoseconds or can operate in the continuous wave mode. Continuous wave dye lasers with linear and ring cavity configurations can be pumped by other lasers, for example argon and krypton ion lasers, resulting in high average power. The bandwidth of the dye lasers can be narrowed with the use of

intracavity etalons resulting in long coherence lengths. Advantages of these laser systems are the added control of wavelength and coherence length.

In the preparation of holograms from the compositions of this invention, the hologram is fixed by a second, overall exposure to actinic radiation. If the hologram is a reflection hologram and the binder is poly(vinyl butyral), poly(vinyl acetate), or a copolymer of vinyl acetate with tetrafluoroethylene and/or hexafluoropropylene containing 3 to 25% by weight fluorine, the refractive index modulation of the hologram can be enhanced by heating to 100-150 °C for about 0.5-1.5 hr following overall exposure.

Holographic Recording Systems

Holography is a form of optical information storage. The general principles are described in a number of references, e.g., "Photography by Laser" by E. N. Leith and J. Upatnieks in Scientific American, 212 (6) 24-35 (June, 1965) . A useful discussion of holography is presented in "Holography", by C. C. Guest, in Encyclopedia of Physical Science and Technolgy, Vol. 6, pp. 507-519, R. A. Meyers, Ed., Academic Press, Orlando, Fla., 1987.

Holograms which modulate the phase, rather than the amplitude, of the beam passing through them are usually referred to as phase holograms. Phase holographic image recording systems produce a spatial pattern of varying refractive index, rather than optical absorption, in the recording medium and, thus, can modulate the incident beam without absorbing it. This type of refractive index image formation also includes a number of optical elements or devices, such as holographic lenses, gratings, mirrors, and optical waveguides, which superficially bear little resemblance to absorption images.

In brief, the object to be imaged is illuminated with coherent light and a light sensitive recording medium is positioned so as to receive light reflected from the object. This beam of reflected light is known as the object beam. At the same time, a portion of the coherent light is directed to the recording medium, bypassing the object. This beam is known as the reference beam. The interference pattern that results from the interaction of the reference beam and the object beam impinging on the recording medium is recorded in the recording medium. When the processed recording medium is subsequently appropriately illuminated and observed at the appropriate angle, the light from the illuminating source is diffracted by the hologram to reconstruct the wavefront that originally reached the recording medium from the object.

Holograms that are formed by allowing the reference and object beams to enter the recording medium from the same side are known as transmission holograms. Transmission holograms may be produced by methods which are well known in the art, such as disclosed in Leith and Upatnieks, U.S. Patents 3,506,327; 3,838,903 and 3,894,787.

Holograms formed by allowing the reference and object beams to enter the recording medium from opposite sides, so that they are traveling in approximately opposite directions, are known as reflection holograms. Reflection holograms may be produced by the on-axis method wherein the beam of coherent radiation is projected through the recording medium onto an object therebehind. In this instance, the reflected object beam returns and interacts with the projected beam in the plane of the recording medium.

Reflection holograms also may be produced by an off-axis method wherein a reference beam is projected on one side of the recording medium and an object beam is projected on the reverse side of the medium. In this instance, the original beam of coherent radiation is split into two portions, one portion being projected on the medium and the other portion being manipulated to project on the object behind the medium. Reflection holograms produced by an off-axis process are disclosed in U.S. Patent 3,532,406.

A holographic mirror is the simplest possible reflection hologram. It can be created by splitting a single laser beam and recombining the beams at the recording medium, or the unsplit laser beam can be projected through the medium onto a plane mirror therebehind. A set of uniformly spaced fringes with a sinusoidal-like intensity distribution is formed which are oriented parallel to the bisector of the obtuse angle between the two beams propagating in the recording medium. If the obtuse angle is 180° and the beams are normal to the plane of the medium, the fringes will be parallel to the plane of the medium. The holographic mirror can be characterized by its wavelength of maximum reflection and by its reflection efficiency, that is the percent of incident radiation which is reflected at its wavelength of maximum reflection.

The theory for thick hologram gratings and mirrors, generally known as the "coupled wave theory", has been developed by Kogelnik (H. Kogelnik, Bell Syst. Tech. J., 48 2909-2947, 1969). According to this theory, a holographic mirror can be characterized by its refractive index modulation. This quantity is a quantitative measure of the sinusoidal modulation of the refractive index within the recording medium produced when the mirror is formed. Using this theory the refractive index modulation of a mirror can be calculated from its reflection efficiency, that is, the percent of incident radiation reflected; thickness; and the

angle and wavelength of the probe radiation. To determine the refractive index modulation for a particular recording material, a holographic mirror is formed in the material, and the thickness and the maximum reflection efficiency of the hologram determined. Since refractive index modulation is thickness and wavelength independent, it is a convenient parameter to use in comparing holographic recording materials.

According to the coupled wave theory, the relationship between reflection efficiency, mirror thickness, wavelength and angle of the probe radiation, and refractive index modulation for a holographic mirror in which the incident radiation is perpendicular to the plane of the mirror (i.e., the film is formed by the on-axis technique), is represented by the equation:

$$\eta = \tanh^2 \left[ \frac{\pi M d}{\lambda} \right]$$

$\eta$ = reflection efficiency of the mirror
M = refractive index modulation
$\lambda$ = wavelength of the probe radiation
d = mirror thickness (i.e., film) thickness

Solving this equation for M, refractive index modulation is calculated as:

$$M = \left[ \frac{\lambda \tanh^{-1} \sqrt{\eta}}{\pi d} \right]$$

Industrial Applicability

The photopolymerizable compositions of this invention show good visible light sensitization which allows them to be exposed with a variety of visible light sources, especially lasers which emit in the longer wavelength region of the visible spectrum. The broad sensitization range enables polymeric images, which may be further processed by development to produce resist images, or other relief images, to be formed. These compositions are useful in printing plates for offset and letter press, engineering drafting films, as well as photoresists in liquid or dry film form for making printed circuits or in chemical milling or in solder masks.

Certain compositions of this invention are particularly useful for the formation of holograms in which sensitivity to visible lasers is required. In particular, the sensitizers used in the compositions of this invention are sensitive to actinic radiation in the red region of the visible spectrum and, when combined with a sensitizer or sensitizers which are sensitive to the actinic radiation in the blue and green regions of the visible spectrum, produce photopolymerizable compositions in which multiple holograms, generated by actinic radiation of different wavelengths, can be prepared. These holograms are particularly useful in the preparation of multicolor display holograms. They can also be used as holographic notch filters when it is desired to protect against more than one wavelength of radiation.

Other specific uses for the compositions of this invention and the holograms and multicolor holograms prepared therefrom will be evident to those skilled in the art.

Syntheses

The squarylium sensitizers of this invention can be prepared by well-known synthetic procedures. Sensitizers 1 and 4 are described in H.-E. Sprenger and W. Ziegenbein, Ang. Chem. Int. Ed., 6, 553-554 (1967). Sensitizer 1 is also described in A. Treibs and K. Jacob, Liebigs Ann. Chem., 699, 153-167 (1966) and 712, 123-137 (1968). The general methods described in these publications can be used to prepare other symmetrical squarylium sensitizers, such as, for example, sensitizers 2 and 3.

Sensitizer 3 was synthesized by: (1) reaction of the p-methoxyphenylhydrazine hydrochloride with 3-methyl-2-butanonein the presence of triethylamine to form the hydrazone; (2) conversion of the hydrazone to an indoline with sulfuric acid using the well-known Fischer indole synthesis; (3) alkylation of the indoline with iodomethane to form an iodide salt which was purified by recrystallization from ethanol (mp 139-142°C); and (4) reaction of the iodide salt with squaric acid in the presence of quinoline to form sensitizer 3

(mp greater than 310 ° C; $\lambda_{max}$ 650 nm; $\epsilon$ 284,000).

Synthetic routes to unsymmetrical squarylium sensitizer intermediates are disclosed in Kampfer, U.S. Patent 3,617,270 and Law, U.S. Patent 4,524,219. The following are illustrative of synthetic routes for the unsymmetrical sensitizers of this invention.

Sensitizer 5 was prepared by: (1) reaction of 1,3,3-trimethyl-2-methyl indoline with 3,4-diethoxy-3-cyclobutene-1,2-dione to form a product (mp 146-148 ° C) which was (2) heated at reflux for 2 hr in N,N-dimethylaniline in the presence of a catalytic amount of sulfuric acid to produce sensitizer 5 ($\lambda_{max}$ 623; $\epsilon$ 122,000) in low yield.

Sensitizer 6 was prepared by: (1) reaction 1-phenethyl-2-picolinium bromide with 3,4-diethoxy-3-cyclobutene-1,2-dione in the presence of triethyl amine to form a product (mp 169-173 ° C) in which one of the ethoxy groups had been replaced by a 1-phenethyl-2-picolinium group and (2) reaction of this product with 1,3,3-trimethyl-2-methylene-indoline in the presence of aqueous-sulfuric acid to form sensitizer 6 (mp greater than 310 ° C; $\lambda_{max}$ 632 nm; $\epsilon$ 387,000)

The advantageous properties of this invention can be observed by reference to the following examples which illustrate, but do not limit, the invention.

## EXAMPLES

### GLOSSARY

| | |
|---|---|
| AIBN | 2,2'-Azobisisobutyronitrile; CAS 78-67-1 |
| CDM-HAB | I 2-(o-chlorophenyl)-4,5-bis(m-methoxyphenyl)imidazole dimer; CAS 29777-36-4 |
| o-C1-HABI | 1,1'-Biimidazole, 2,2'-bis[o-chlorophenyl]-4,4',5,5'-tetraphenyl-; CAS 1707-68-2 |
| FC-431 | Fluorad® FC-431, liquid nonionic surfactant; 50% solution of fluoroaliphatic polymeric esters in ethyl acetate; 3M Company |
| 9-JA | 9-Julolidine carboxaldehyde; 9-Carboxaldehyde, 2,3,6,7-tetrahydro-1H,5H-benzo-[i,j]quinolizine; CAS 33985-71-6 |
| JAW | Cyclopentanone, 2,5-bis[(2,3 6,7-tetrahydro-1H 5H-benzo [i,j]quinolizin-9-yl)-methylene]- |
| MMT | 4-Methyl-4H-1,2,4-triazole-3-thiol; CAS 24854-43-1 |
| p-$NO_2$-HABI | 1,1'-Biimidazole, 2,2'-bis[p-nitrophenyl]-4,4',5,5'-tetraphenyl-; |
| NVC | N-Vinyl carbazole; 9-vinyl carbazole; CAS 1484-13-5 |
| Photomer® 4039 | Phenol ethoxylate monoacrylate; CAS 56641-05-5; Henkel Process Chemical Company |
| Sartomer 349 | Ethoxylated bisphenol A diacrylate; CAS 24447-78-7; Sartomer Company, West Chester, PA. |
| Sensitizer 1 | 3H-Indolium, 2-[[3-[(1,3-dihydro-1,3,3-trimethyl-2H-indol-2-ylidene)methyl]-2-hydroxy-4-oxo-2-cyclobuten-1-ylidene]-methyl]-1,3,3-trimethyl-, hydroxide, inner salt; CAS 14238-53-0 |
| Sensitizer 2 | 3H-Indolium, 5-chloro-2-[[3-[(5-chloro1,3-dihydro-1,3,3-trimethyl-2H-indol-2-ylidene)methyl]-2-hydroxy-4-oxo-2-cyclobuten-1-ylidene]methyl]-1,3,3-trimethyl-, hydroxide, inner salt |
| Sensitizer 3 | 3H-Indolium, 5-methoxy-2-[[3-[(5-methoxy-1,3-dihydro-1,3,3-trimethyl-2H-indol-2-ylidene)methyl]-2-hydroxy-4-oxo-2-cyclobuten-1-ylidene]methyl]-1,3,3-trimethyl-, hydroxide, inner salt |
| Sensitizer 4 | Benzothiazolium, 3-ethyl-2-[[3-[3-ethyl-2(3H)-benzothiazolylidene)methyl]-2-hydroxy-4-oxo-2-cyclobuten-1-ylidene]-methyl]-, hydroxide, inner salt; CAS 109201-66-3 |
| Sensitizer 5 | 3H-Indolium, 2-[[3-[(4-(dimethylamino)-phenyl]-2-hydroxy-4-oxo-2-cyclobuten-1-ylidene]methyl]-1,3,3-trimethyl-, hydroxide, inner salt |
| Sensitizer 6 | 3H-Indolium, 2-[[2-hydroxy-4-oxo-3-[[1-(2-phenylethyl)-2(1H)-pyridinylidene]-methyl]-2-cyclobuten-1-ylidene]methyl]-1,3,3-trimethyl-, hydroxide, inner salt |
| TFE | Tetrafluoroethylene |
| Vinac® B-100 | Poly(vinyl acetate); M.W. 350,000; CAS 9003-20-7; Air Products; Allentown, PA |

## GENERAL PROCEDURES

### Film Preparation

Coating solutions without sensitizing dyes were prepared in amber bottles under yellow or red light by adding the components to the solvents while mixing with a mechanical stirrer until completely dissolved. All components were used as received from the suppliers without further purification. The squarylium sensitizers were prepared as described above. The squarylium sensitizer, was added under low level red light (i.e., safelight) and all subsequent operations on solutions and their resulting films were performed under low level red light only. It should be understood that "total solids" refers to the total amount of non-volatile components in the composition even though some of the components may be non-volatile liquids rather than solids at room temperature.

A Talboy coater equipped with a doctor knife, 12 ft (3.7 m) drier set at 50-70 °C, and a laminator station was used to coat the solutions onto a 2-mil (0.05 mm) thick clear film support of polyethylene terephthalate film. A coversheet 0.92-mil (0.023 mm) polyethylene terephthalate was laminated to the coatings as they emerged from the drier. Coated samples were stored in black polyethylene bags at room temperature until used.

## Sample Evaluation

Coated film with both the film support and coversheet intact was cut into 10x13 cm sections. The coversheet was removed, and the film was then mounted by laminating the soft, tacky coating onto a clear glass plate. The film support was left in place during exposure and processing operations. The plate was clamped to a front-surface mirror with a thin layer of xylene in between. The thin layer of xylene served to optically couple the glass and mirror to the film.

Holographic mirrors were recorded in the film by exposing with a collimated laser beam orientated perpendicular to the film surface so that the beam passed, in order, through the glass plate, coating, film support, and xylene layer and then reflected back onto itself off the mirror surface. The laser beam diameter was 2.0 cm. For 633 nm exposure a HeNe laser, beam intensity about 10-15 $mW/cm^2$, was used. For 647 nm irradiation a krypton-ion laser beam, intensity at the sample about 11 $mW/cm^2$, was used. To determine the photospeed of the composition, sixteen mirrors with varying exposures were recorded for each sample.

After the recording the holographic mirrors, the film samples were overall exposed to ultraviolet and visible light using the output of a Theimer-Strahler #5027 mercury-arc photopolymer lamp (Exposure Systems Corp., Bridgeport, CT) mounted in a Douthitt DCOP-X (Douthitt Corp., Detroit, MI) exposure unit. The exposed coatings were then heat processed with the film support in place by placing them in a conventional forced-air convection oven at 100 °C for 30 to 60 min.

The transmission spectrum of each holographic mirror was recorded from 400-700 nm using a Perkin Elmer model Lambda-9 spectrophotometer. Maximum reflection efficiency and reflection wavelength were determined from the transmission spectra. Photospeed was determined from plots of reflection efficiency versus exposure energy by choosing the minimum energy needed to obtain maximum efficiency. Coating thickness was measured in processed and analyzed holographic mirrors using a profilometer (Sloan-Dektac Model 3030). The coating thickness, reflection wavelength, and maximum attainable reflection efficiency were used to calculate the refractive index modulation for each coating using the well-known coupled wave theory, previously described.

## Examples 1-9

A coating composed of 13.2 gm (66.0%) Vinac® B-100; 0.016 gm (0.08%) of the indicated sensitizer; 0.42 gm (2.1%) MMT; 0.74 gm (3.7%) of the indicated HABI; 0.60 gm (3.0%) Sartomer 349; 1.58 gm (7.9%) NVC; 3.40 gm (17.0%) Photomer® 4039; and 0.04 gm (0.2%) FC-431 dissolved in a mixture of 76 gm of dichloromethane and 4 gm of methanol was prepared and coated as described in the general procedures. The samples were exposed and processed to produce holographic mirrors as described in the general procedure. The sensitizer and HABI used, the wavelength used for exposure, photospeed, and refractive index modulation of the resulting holograms are given in Table 1.

Table 1

| Example | Sensitizer | HABI | Wavelength (nm) | Photospeed ($mJ/cm^2$) | RIM[a] |
|---|---|---|---|---|---|
| 1 | 1 | o-Cl | 633 | 530 | 0.022 |
| 2 | 1 | CDM | 633 | 480 | 0.023 |
| 3 | 1 | p-$NO_2$ | 633 | 620 | 0.030 |
| 4 | 2 | CDM | 633 | 710 | 0.016 |
| 5 | 3 | CDM | 647 | 545 | 0.033 |
| 6 | 4 | CDM | 633 | 910 | 0.025 |
| 7 | 5 | CDM | 633 | 480 | 0.025 |
| 8 | 6 | o-Cl | 633 | 710 | 0.019 |
| 9 | 6 | CDM | 633 | 545 | 0.030 |

[a]Refractive Index Modulation

Examples 10-12

A coating composed of 13.2 gm (66.0%) 82:18 (weight %) vinyl acetate/TFE copolymer; 0.016 gm (0.08%) of the indicated sensitizer; 0.42 gm (2.1%) MMT; 0.74 gm (3.7%) of the indicated HABI; 0.60 gm (3.0%) Sartomer 349; 1.58 gm (7.9%) NVC; 3.40 gm (17.0) Photomer® 4039; and 0.04 gm (0.2%) FC-431 dissolved in a mixture of 76 gm of dichloromethane and 4 gm of methanol was prepared and coated as described in the general procedures. The samples were exposed and processed to produce holographic mirrors as described in the general procedure. The sensitizer and HABI used, the wavelength used for exposure, photospeed, and refractive index modulation of the resulting holograms are given in Table 2.

Table 2

| Example | Sensitizer | HABI | Wavelength (nm) | Photospeed ($mJ/cm^2$) | RIM[a] |
|---|---|---|---|---|---|
| 10 | 1 | o-Cl | 633 | 480 | 0.048 |
| 11 | 1 | CDM | 633 | 250 | 0.050 |
| 12 | 3 | CDM | 647 | 325 | 0.050 |

[a]Refractive Index Modulation

Example 13

This example illustrates the preparation of a vinyl acetate/TFE copolymer which can be used as a binder in a holographic photopolymer composition.

Vinyl acetate (76.2 g), AIBN (0.15 g), methyl acetate (20 g), and t-butyl alcohol (100 g) were added to a

400 mL shaker tube. The tube was cooled in a dry ice-acetone bath, and evacuated. TFE (20 g) was added and the tube was maintained at 60 °C for 4 hr. The tube was cooled to room temperature and the reaction mixture was removed. The tube was washed with acetone. The combined products and washings from two identical runs were dissolved in acetone, filtered, precipitated by adding acetone solution to cold water in a Waring blender, and dried to constant weight in a vacuum oven. Yield was 147 g of the vinyl acetate/TFE copolymer. Monomer conversion: 81%. Vinyl acetate content: 78% by weight.

Example 14

This example illustrates the synthesis of a sensitizer which can used with a squarylium sensitizer of this invention to produce a photopolymerizable composition which is both sensitive to and is capable of recording holograms in the blue, green, and red, either separately or in combination.

JAW was synthesized by the base catalyzed condensation of 9-JA with cyclopentanone. In 225 mL of methanol was dissolved 11.4 g (0.135 M) of cyclopentanone, 55.0 g (0.273 M) of 9-JA, and 2.8 g (0.07 M) of sodium methoxide. The reaction mixture, heated at reflux, quickly turned dark red and red solid began to separate. After 7.5 hr of heating at reflux, the reaction mixture was allowed to cool to room temperature. After standing for about 40 hr, the reaction mixture was cooled in an ice bath. The resulting red precipitate was filtered off and washed with cold methanol. Yield: 55.0 g (89%) of red crystals. mp 268-278 °C with decomposition. $\lambda_{max}$(dichloromethane) 496 nm ($\epsilon$ 62,000)

Example 15

This example illustrates the use of a combination of a squarylium sensitizer of this invention with another sensitizer to prepare a photopolymerizable composition which is both sensitive to, and is capable of recording holograms in, the blue, green, and red regions on the visible spectrum, either separately or in combination. The preparation of two and three colored holograms is also illustrated.

The coating was prepared from a solution of of 23.1 gm (65.8% by weight total solids) 78:22 (weight %) vinyl acetate/TFE polymer prepared in example 13, 6.02 gm (17.1%) Photomer® 4039, 2.77 gm (7.9%) NVC, 1.06 gm (3.0%) Sartomer 349, 0.75 gm (2.1%) MMT, 1.32 gm (3.8%) o-Cl-HABI, 0.073 gm (0.21%) FC-430, 0.021 gm (0.060%) JAW, and 0.009 gm (0.026%) sensitizer 1, dissolved in a mixture of 148.4 gm of dichloromethane, 8.3 gm of 2-butanone and 8.2 gm of methanol was prepared and coated as described in the general procedures.

Samples were prepared and exposed as described in the general procedures except holographic mirrors were recorded in the film by exposing with either a collimated 488 nm or 514 nm argon-ion or 647 nm krypton-ion laser beam orientated perpendicular to the film surface. The laser beam diameter was 2.0 cm and its intensity at the sample was about 10 mW/cm$^2$ for 488 and 514 nm exposures, and 11 mW/cm$^2$ for 647 exposures. On each film 16 images were recorded. Exposure times for each series of mirrors ranged between about 0.1 and 5 sec (1 to 50 mJ/cm$^2$) for 488 and 514 nm exposures, and 9 to 55 sec (100 to 600 mJ/cm$^2$) for 647 nm exposures. Reflection efficiencies are given in Table 3.

Table 3

| | Imaging Wavelength (nm) | | |
|---|---|---|---|
| | 488 | 514 | 647 |
| Thickness (microns) | 24 | 24 | 24 |
| Reflection wavelength (nm) | 482 | 506 | 635 |
| fwhm (nm)[a] | 25 | 25 | 22 |
| Maximum Optical density | >3.5 | >3.5 | 2.9 |
| Film speed, $mJ/cm^2$ | 15 | 15 | 400 |

[a]bandwidth at half maximum

Three different holographic images, each consisting of two holographic mirrors formed in a common region of the film, were formed by exposing in a manner similar to that described above, first with a 647 nm collimated laser beam followed by a 514 nm collimated laser beam. The film was processed as described in the general procedures. Reflection efficiencies are given in Table 4.

Table 4

| | Image #1 | Image #2 | Image #3 |
|---|---|---|---|
| Exposure at 647 nm ($mJ/cm^2$) | 231 | 260 | 293 |
| Exposure at 514 nm ($mJ/cm^2$) | 5 | 4 | 3 |
| Peak 1 Wavelength (nm) | 635 | 635 | 635 |
| Reflection Efficiency (%) | 81 | 89 | 88 |
| Peak 2 Wavelength (nm) | 505 | 505 | 505 |
| Reflection Efficiency (%) | 97 | 88 | 66 |

A film was imaged in a similar fashion using three sequential exposures at 647, 514 and 476 nm. The mirror was imaged as described in the general procedures except that a white diffuse reflector was used in place of a mirror. Exposures were, in order, 647 nm, 200 $mJ/cm^2$; 528 nm, 7 $mJ/cm^2$; and 476 nm, 20 $mJ/cm^2$. The final image consisted of three holographic mirrors within a common area: 32% reflection at 472 nm, 45% at 522 nm, and 38% at 640 nm.

**Claims**

**1.** A photopolymerizable composition having extended spectral response, said composition comprising:
(a) a squarylium sensitizer of the following structure:

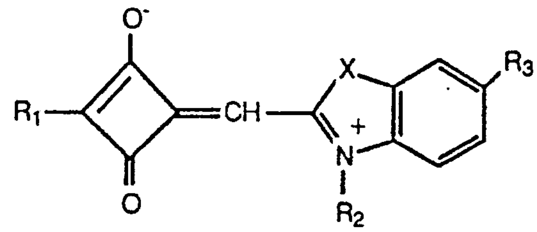

where

R1 is:

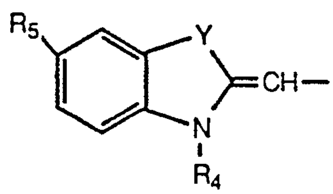 , 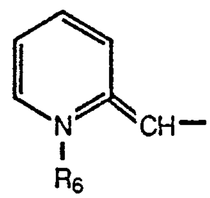 ,

A B

or a p-(N,N-dialkylamino)phenyl in which the alkyl groups are from about 1 to about 4 carbon atoms;
X and Y are each independently O, S, $NR_7$, or $CR_8R_9$, where $R_7$, $R_8$, and $R_9$ are each independently an alkyl group of about 1 to about 6 carbon atoms or substituted or unsubstituted phenyl;
$R_2$ and $R_4$ are each independently a substituted or unsubstituted alkyl group from about 1 to about 7 carbon atoms;
$R_3$ and $R_5$ are each independently H, Cl, or $OCH_3$ with the proviso that when X is S, $R_3$ is H and that when Y is S, $R_5$ is H; and
$R_6$ is a substituted or unsubstituted alkyl group of from about 1 to about 8 carbon atoms;

(b) a hexaarylbisimidazole of the following structure:

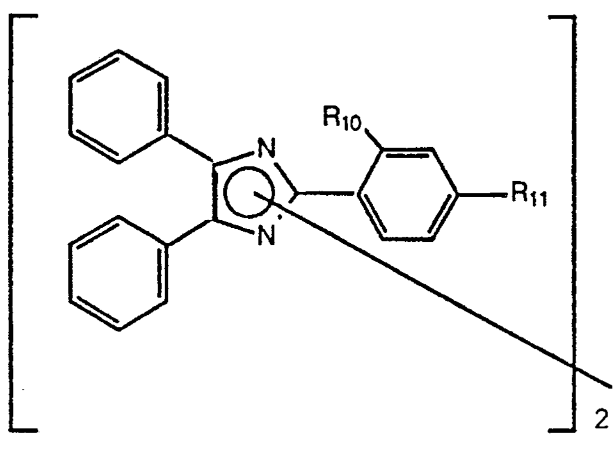

where
$R_{10}$ is Cl, H or $CH_3$, and $R_{11}$ is Cl, $NO_2$ H, $CH_3$ or $OCH_3$ with the proviso that either $R_{10}$ is Cl or $R_{11}$ is Cl or $NO_2$; and any other position on the three phenyl radicals of (b) is either unsubstituted or

substituted with Cl, $CH_3$, or $OCH_3$;
(c) at least one an ethylenically unsaturated monomer capable of free radical initiated addition polymerization; and
(d) a chain transfer agent.

2. The composition of claim 1 wherein said squarylium sensitizer is selected of the group consisting of: 3H-Indolium, 2-[[3-[(1,3-dihydro-1,3,3-trimethyl-2H-indol-2-ylidene) methyl]-2-hydroxy-4-oxo-2-cyclobuten-1-ylidene]methyl]-1,3,3-trimethyl-, hydroxide, inner salt;
3H-Indolium, 5-chloro-2-[[3-[(5-chloro-1,3-dihydro-1,3,3-trimethyl-2H-indol-2-ylidene)methyl]-2-hydroxy-4-oxo-2-cyclobuten-1-ylidene]methyl]-1,3,3-trimethyl-, hydroxide, inner salt;
3H-Indolium, 5-methoxy-2-[[3-[(5-methoxy-1,3-dihydro-1,3,3-trimethyl-2H-indol-2-ylidene)methyl]-2-hydroxy-4-oxo-2-cyclobuten-1-ylidene]methyl]-1,3,3-trimethyl-, hydroxide, inner salt;
Benzothiazolium, 3-ethyl-2-[[3-[3-ethyl-2(3H)-benzothiazolylidene)methyl]-2-hydroxy-4-oxo-2-cyclobuten-1-ylidene]methyl]-, hydroxide, inner salt;
3H-Indolium, 2-[[3-[(4-dimethylamino)phenyl]-2-hydroxy-4-oxo-2-cyclobuten-1-ylidene]-methyl]-1,3,3-trimethyl-, hydroxide, inner salt; and
3H-Indolium, 2-[[2-hydroxy-4-oxo-3-[[1-(2-phenylethyl)-2(1H)-pyridinylidene]methyl]-2-cyclobuten-1-ylidene]methyl]-1,3,3-trimethyl-, hydroxide, inner salt.

3. The composition of claim 1 wherein the hexaarylbisiimidazole is selected from the group consisting of: 1,1'-biimidazole, 2,2'-bis(o-chlorophenyl)-4,4',5,5'-tetraphenyl-; 2-(o-chlorophenyl)-4,5-bis(m-methoxyphenyl)-imidazole dimer; 1,1'biimidazole, 2,2'-bis[p-nitrophenyl]-4,4',5,5'-tetraphenyl-; and 1H-imidazole, 2,5-bis(o-chlorophenyl)-4-[3,4-dimethoxyphenyl]-, dimer.

4. The composition of claim 1 additionally comprising a sensitizer which absorbs in the shorter wavelength region of the visible spectrum.

5. The composition of claim 1 wherein the composition has the following composition based on the total weight of the composition: photoinitiator system about 0.3% to about 15%; monomer about 80% to about 99%; and other ingredients about 0% to about 5%.

6. The composition of claim 1 additionally comprising a polymeric binder.

7. The composition of claim 6 wherein X and Y are each independently S or $CR_8R_9$.

8. The composition of claim 7 wherein said binder is solvent soluble and either said monomer or said binder contains a substituent selected from the group consisting of (1) an aromatic moiety selected from the group consisting of (i) substituted or unsubstituted phenyl, (ii) substituted or unsubstituted naphthyl, and (iii) substituted or unsubstituted heterocyclic aromatic moiety having up to three rings; (2) chlorine; (3) bromine and mixtures thereof; and the other constituent is substantially free of said substituent.

9. The composition of claim 8 wherein said monomer contains said substituent and said binder is substantially free of said substituent.

10. The composition of claim 7 wherein the composition has the following composition based on the total weight of the compositicn: binder, 25 to 90%, monomer, 5 to 60%, photoinitiator system, 0.1 to 10%, and other ingredients, 0 to 30%.

11. The composition of claim 7 wherein $R_1$ is moiety A; X and Y are identical and equal to $C(CH_3)_2$; $R_2$ and $R_4$ are identical and equal to $CH_3$ or $C_2H_5$; and $R_3$ and $R_5$ are identical.

12. The composition of claim 7 wherein $R_{10}$ is Cl and/or $R_{11}$ is Cl or $NO_2$, with the proviso that $R_{11}$ may be H, $CH_3$ or $OCH_3$ when $R_{10}$ is Cl, and that $R_{10}$ may be H, Cl or $CH_3$ when $R_{11}$ is Cl or $NO_2$; and, the other positions on the phenyl radicals are either unsubstituted or substituted with Cl, $CH_3$ or $OCH_3$.

13. The composition of claim 11 wherein $R_{10}$ is Cl and/or $R_{11}$ is Cl or $NO_2$, with the proviso that $R_{11}$ may be H, $CH_3$ or $OCH_3$ when $R_{10}$ is Cl, and that $R_{10}$ may be H, Cl or $CH_3$ when $R_{11}$ is Cl or $NO_2$; and, the

other positions on the phenyl radicals are either unsubstituted or substituted with Cl, $CH_3$ or $OCH_3$.

**14.** The composition of claim 13 wherein said monomer or monomers contain a substituent selected from the group consisting of (1) an aromatic moiety selected from the group consisting of (i) substituted or unsubstituted phenyl, (ii) substituted or unsubstituted naphthyl, and (iii) substituted or unsubstituted heterocyclic aromatic moiety having up to three rings; (2) chlorine; (3) bromine and mixtures thereof; and said binder is substantially free of said substituent.

**15.** The composition of claim 14 wherein said binder is selected from the group consisting of cellulose acetate butyrate, poly(methyl methacrylate), poly(vinyl butyral), poly(vinyl acetate), or copolymers of vinyl acetate with tetrafluoroethylene and/or hexafluoropropylene containing 3 to 25% by weight fluorine, and mixtures thereof.

**16.** The composition of claim 15 additionally comprising a sensitizer which absorbs in the shorter wavelength region of the visible spectrum, wherein said sensitizer is cyclopentanone, 2,5-bis[(2,3,6,7-tetrahydro-1H,5H-benzo[i,j]quinolizin-9-yl)methylene]-.

**17.** The composition of claim 12 wherein $R_2$ and $R_4$ are identical and equal to $CH_3$; and $R_3$ and $R_5$ are identical and equal to H or Cl.

**18.** The composition of claim 17 in which $R_3$ and $R_5$ are identical and equal to H.

**19.** A process for forming a light-stable hologram comprising exposing to modulated actinic radiation comprising an object beam and a reference beam bearing holographic information a photopolymerizable layer comprising:

(a) a squarylium sensitizer of the following structure:

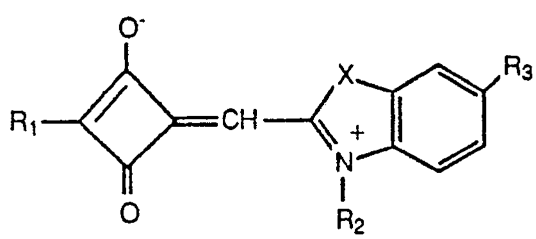

where

$R_1$ is:

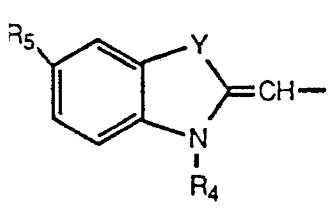 , 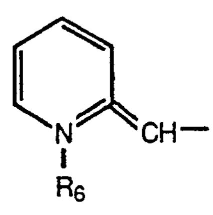 ,

A B

or a p-(N,N-dialkylamino)phenyl in which the alkyl groups are from about 1 to about 4 carbon atoms;

X and Y are each independently O, S, $NR_7$, or $CR_8R_9$ where $R_7$, $R_8$, and $R_9$ are each independently an alkyl group of about 1 to about 6 carbon atoms or substituted or unsubstituted phenyl;

$R_2$ and $R_4$ are each independently a substituted or unsubstituted alkyl group from about 1 to about 7 carbon atoms;

$R_3$ and $R_5$ are each independently H, Cl or $OCH_3$ with the proviso that when X is S, $R_3$ is H and that when Y is S, $R_5$ is H; and
$R_6$ is a substituted or unsubstituted alkyl group of from about 1 to about 8 carbon atoms;

(b) a hexaarylbisimidazole of the following structure:

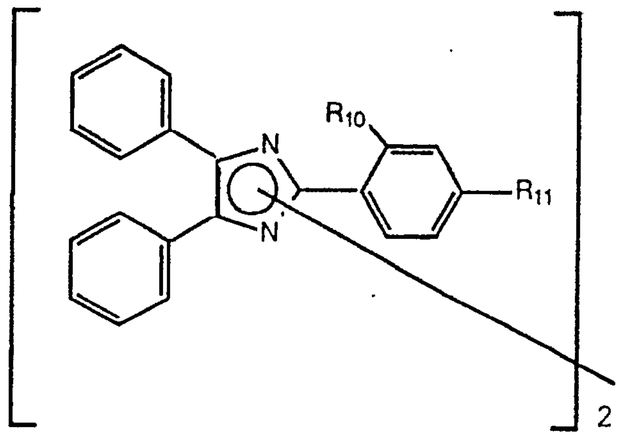

where
$R_{10}$ is Cl, H or $CH_3$, and $R_{11}$ is Cl, $NO_2$, H, $CH_3$ or $OCH_3$ with the proviso that either $R_{10}$ is Cl or $R_{11}$ is C1 or $NO_2$; and, any other position on the three phenyl radicals of (b) is either unsubstituted or substituted with Cl, $CH_3$ or $OCH_3$;

(c) a solvent soluble, polymeric binder; and
(d) at least one ethylenically unsaturated monomer capable of free radical initiated addition polymerization and having a boiling point above 100° C.

**20.** The process of claim 19 additonally comprising a second, overall exposure to actinic radiation.

**21.** The process of claim 20 wherein the composition has the following composition based on the total weight of the composition: binder 25 to 90%, monomer, 5 to 60%, photoinitiator system 0.1 to 10%, and other ingredients, 0 to 30%.

**22.** The process of claim 21 wherein X and Y are each independently S or $CR_8R_9$.

**23.** The process of claim 22 wherein said binder is solvent soluble and either said monomer or said binder contains a substituent selected from the group consisting of (1) an aromatic moiety selected from the group consisting of (i) substituted or unsubstituted phenyl, (ii) substituted or unsubstituted naphthyl, and (iii) substituted or unsubstituted heterocyclic aromatic moiety having up to three rings; (2) chlorine; (3) bromine and mixtures thereof; and the other constituent is substantially free of said substituent.

**24.** The process of claim 23 wherein said monomer contains said substituent and said binder is substantially free of said substutuent.

**25.** The process of claim 23 wherein $R_1$ is moiety A; X and Y are identical and equal to $C(CH_3)_2$; $R_2$ and $R_4$ are identical and equal to $CH_3$ or $C_2H_5$; and $R_3$ and $R_5$ are identical.

**26.** The process of claim 23 wherein $R_{10}$ is Cl and/or $R_{11}$ is Cl or $NO_2$, with the proviso that $R_{11}$ is H, $CH_3$ or $OCH_3$ when $R_{10}$ is Cl, and that $R_{10}$ is H, Cl or $CH_3$ when $R_{11}$ is Cl or $NO_2$; and, the other positions on the phenyl radicals are either unsubstituted or substituted with Cl, $CH_3$ or $OCH_3$.

**27.** The process of claim 25 wherein $R_{10}$ is Cl and/or $R_{11}$ is Cl or $NO_2$, with the proviso that $R_{11}$ is H, $CH_3$ or $OCH_3$ when $R_{10}$ is Cl, and that $R_{10}$ is H, Cl or $CH_3$ when $R_{11}$ is Cl or $NO_2$; and, the other positions on the phenyl radicals are either unsubstituted or substituted with Cl, $CH_3$ or $OCH_3$.

28. The process of claim 27 wherein said binder is selected from the group consisting of cellulose acetate butyrate, poly(methyl methacrylate), poly(vinyl butyral), poly(vinyl acetate), or copolymers of vinyl acetate with tetrafluoroethylene and/or hexafluoropropylene containing 3 to 25% by weight fluorine, and mixtures thereof.

29. The procees of claim 27 wherein said photopolymerizable composition additionally comprises a sensitizer which absorbs in the shorter wavelength region of the visible spectrum.

30. The process of claim 21 wherein said object beam and said reference beam are incident on opposite sides of said photopolymerizable layer.

31. The process of claim 30 additionally comprising the step of heating said photopolymerizable composition to 100-150 °C for about 0.5-1.5 hr following said second, overall exposure.